# EUROPEAN PATENT SPECIFICATION

(11) **EP 1 327 928 B1**
(45) Date of publication and mention of the grant of the patent: **04.03.2009**
(21) Application number: 00953563.4
(22) Date of filing: 22.08.2000
(51) Int. Cl.: G06F 3/00, H01R 13/719

(54) **CONNECTOR RECEPTACLE**
VERBINDERAUFNAHME
EMBASE DE CONNECTEUR

(43) Date of publication of application: 16.07.2003
(73) Proprietor: Panasonic Electric Works Co., Ltd., Kadoma-shi Osaka (JP)
(72) Inventor: HASHIMOTO, Takeshi, c/o Matsushita Electric Works, Ltd, Kadoma-shi, Osaka 571-8686 (JP); KANBE, Yoshiaki, c/o Matsushita Electric Works, Ltd., Kadoma-shi, Osaka 571-8686 (JP); ITO, Takayasu, c/o Matsushita Electric Works, Ltd., Kadoma-shi, Osaka 571-8686 (JP); MATSUSHIMA, Syunsuke, c/o Matsushita Electric Works, Ltd., Kadoma-shi, Osaka 571-8686 (JP)
(74) Representative: Pfenning, Meinig & Partner GbR
(86) International application number: PCT/JP2000/005619
(87) International publication number: WO 2002/017053

(56) References cited:
- DE-A1- 19 621 429
- JP-A- 2 117 077
- JP-A- 6 019 516
- JP-A- 6 151 011
- JP-A- 6 151 011
- JP-A- 7 085 929
- US-A- 4 686 506
- US-A- 5 522 727
- US-A- 5 772 453
- US-A- 6 089 879

## Description

### TECHNICAL FIELD

The present invention relates to a connector receptacle used for high-speed transmission of a digital signal.

### BACKGROUND ART

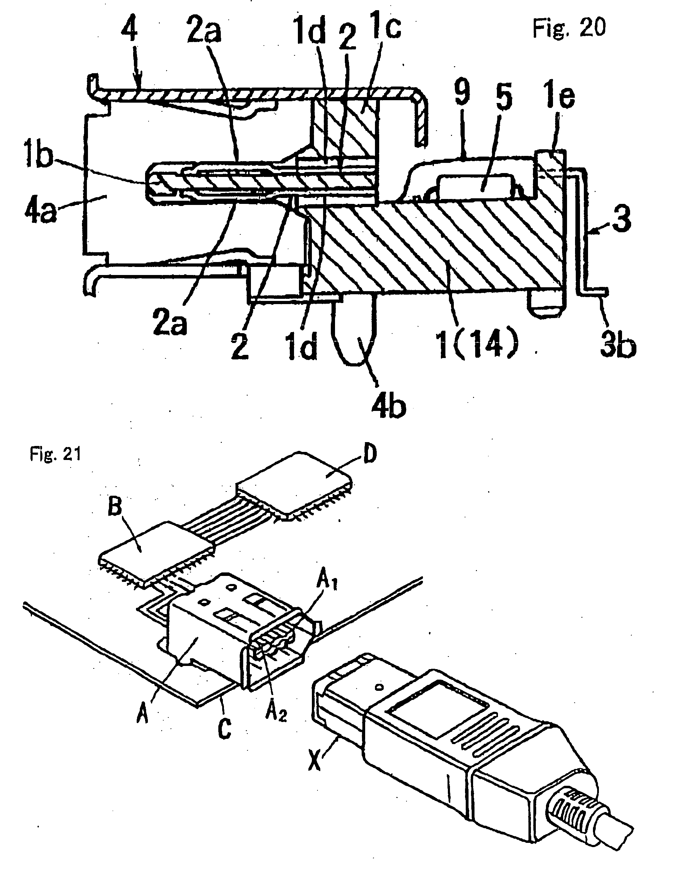

Conventionally, a connector apparatus shown in Fig. 21 is used for high-speed transmission of a digital signal. The apparatus comprises a connector receptacle A, a physical layer basic circuit B and a printed circuit board C.

The connector receptacle A comprises a mating portion A₁ to which a connector plug X is mated with and a plurality of contacts A₂ individually connected to connecting portions of the connector plug X fit in the mating portion A₁.

The physical layer basic circuit B is formed of a LSI and the physical layer basic circuit B performs predetermined operations such as serial-parallel conversion, encoding and decoding operations and connector input-output control so that a data signal is communicated in series from the connector plug X to the contacts A₂ and the data signal is communicated in parallel with a link layer circuit D for communication.

On the printed circuit board C, the LSI constituting the physical layer basic circuit B is mounted and transmission lines through which the data signal is transmitted from the connector plug X to the link layer circuit D are patterned.

According to the above-described conventional technology, that is, the technology in which the LSI constituting the physical layer basic circuit B is mounted onto the printed circuit board C, the transmission lines patterned on the printed circuit board C exerts large influence on EMI or transmission characteristics depending on its patterned layout when the digital data signal is transmitted at high speed. Therefore, it is necessary to pay enough attention to design the layout of the patterns so as to prevent the influence on the EMI or the transmission characteristic, which arises a problem in that it is difficult to design the layout of the patterns of the transmission lines for the data signal.

US-A-4 686 506 discloses a multiple connector having a male connection interface adapted for direct integrated electrical mating with a printed circuit board member which handles data in a parallel format. This connector further has multiple female connection interfaces for mating connection with corresponding external male connection interface members from one or more external devices which handle data in a serial format. Means for converting data from said parallel format to said serial format and means for converting data from said serial format to said parallel format are electrically positioned between the male connection interface and the female connection interfaces within the connector. The connector is adapted to be physically supported by the printed circuit board.

The present invention was made in view of the above problem and it is an object of the present invention to provide a connector receptacle in which it is easy to design a layout of patterns constituting transmission lines for the data signal.

### DISCLOSURE OF THE INVENTION

This object according to the in invention is solved by a connector receptacle comprising the features of claim 1. Preferred embodiments of this connector receptacle are defined in the subclaims.

A connector receptacle according to the present invention comprises a mating portion to mate with a connector plug and a plurality of contacts connectable to the connector plug, the connector receptacle further comprising a physical layer basic circuit performing predetermined operations so that a data signal can be communicated in series with the contacts through the connector plug and the data signal can be communicated in parallel with a link layer circuit for communication. Furthermore, the data signal is transmittable in parallel through transmission lines which are N times as many compared with those for communication in series, and a rise time and fall time when the data signal is communicated in parallel is N times as long compared with that when it is communicated in series.

Thus, since the physical layer basic circuit is provided at the connector receptacle itself, the distance between the contacts and the physical layer basic circuit is shorter than the conventional example in which the physical layer basic circuit is mounted on the printed circuit board. Also, a high frequency ingredient is alleviated and the EMI can be reduced. Therefore, it is not necessary to pay so much attention as in the conventional example in designing a pattern layout so as to prevent an influence on an EMI or transmission characteristic and it becomes easy to design the layout of the patterns constituting transmission lines for the data signal.

In addition, the following configurations are desirable, that is, the configuration in which the data signal is communicated in series from the contacts to the physical layer basic circuit through the transmission lines each having almost constant characteristic impedance, or the configuration in which the data signal is transmitted from each of the plurality of contacts to the physical layer basic circuit through the transmission lines each having almost the same length. In such configurations, a reflection of the data signal at the time of input-output can be reduced and skew between the data signals can be also reduced.

In addition, when there is provided a shielding member for shielding the transmission lines from the outside to which the data signal is transmitted from the connector plug, the EMI is further reduced.

Furthermore, when the physical layer basic circuit is provided on the substrate and the contacts are positioned so as to be at almost the same plane as the substrate, bending portions of the transmission lines can be reduced, whereby the transmission characteristic can be improved.

Meanwhile, it is possible to provide a plurality of the mating portions. At this time, if the physical layer basic circuit performs predetermined operations so that the data signal is transmitted in series with the connector plugs mate with the plurality of the fitting portions and it is communicated in parallel with the link layer circuit, there is only one physical layer basic circuit and thus, the whole size can be miniaturized.

Furthermore, it is possible that the physical layer basic circuit is provided on an MID substrate and the contacts are held on the MID substrate. Thus, since it is not necessary to additionally provide a member for holding the contacts, the number of parts can be reduced.

### BRIEF DESCRIPTION OF THE DRAWINGS

Fig. 1 is a perspective view showing a connector receptacle according to an embodiment 1 of the present invention.
Fig. 2 is a front view showing the connector receptacle.
Fig. 3 is a side view showing the connector receptacle.
Fig. 4 is a plane view showing the connector receptacle.
Fig. 5 is a side sectional view showing the connector receptacle.
Fig. 6 is a functional block diagram showing a physical layer basic circuit provided in the connector receptacle.
Fig. 7 is an explanatory drawing showing a transmission state of a data signal in the connector receptacle.
Fig. 8 is an explanatory drawing for comparing a transmission state of parallel communication with a transmission state of serial communication in the connector receptacle.
Fig. 9 is a perspective view showing a connector receptacle according to an embodiment 2 of the present invention.
Fig. 10 is a plan view showing the connector receptacle shown in Fig. 9.
Fig. 11 is a partially enlarged plan view showing the connector receptacle shown in Fig. 9.
Fig. 12 is a side sectional view showing the connector receptacle shown in Fig. 9.
Fig. 13 is a partially sectional view showing a transmission line in the connector receptacle shown in Fig. 9.
Fig. 14 is a perspective view showing a connector receptacle according to an embodiment 3 of the present invention.
Fig. 15 is a plane view showing the connector receptacle shown in Fig. 14.
Fig. 16 is a partially enlarged plane view showing the connector receptacle shown in Fig. 14.
Fig. 17 is a side sectional view showing the connector receptacle shown in Fig. 14.
Fig. 18 is a perspective view showing a connector receptacle according to an embodiment 4 of the present invention.
Fig. 19 is a plane view showing the connector receptacle shown in Fig. 18.
Fig. 20 is a side sectional view showing the connector receptacle shown in Fig. 18.
Fig. 21 is a perspective view showing a conventional example.

### BEST MODE FOR CARRYING OUT THE INVENTION

### [Embodiment 1]

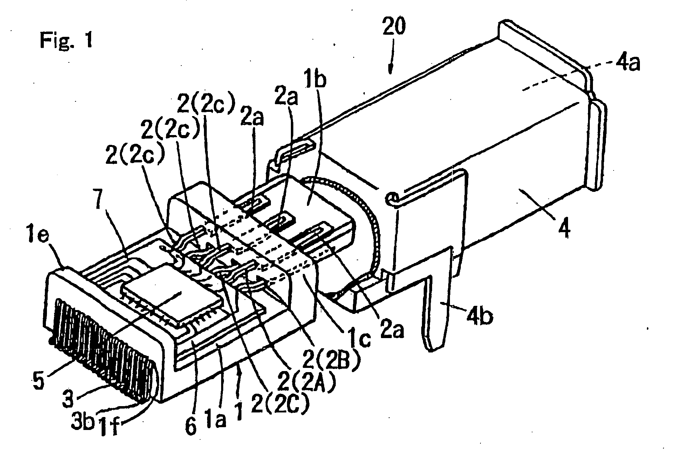

A connector receptacle according to an embodiment 1 of the present invention will be described in reference to Figs. 1 to 8. As shown in Fig. 1, the connector receptacle 20 comprises a housing 1, contacts 2, terminals 3, a shell 4, a physical layer basic circuit 5 and a substrate 6. A digital signal is communicated at high speed through the connector receptacle 20.

The housing 1 is formed of an insulating material and there is provided a substrate bonded portion 1a on which the substrate 6 is bonded by digging its central portion such that its both ends are left. In addition, in the housing 1, a contact supporting portion (Insertion Wafer) 1b to which a connector plug X (not shown) is mated with is extended from its one end.

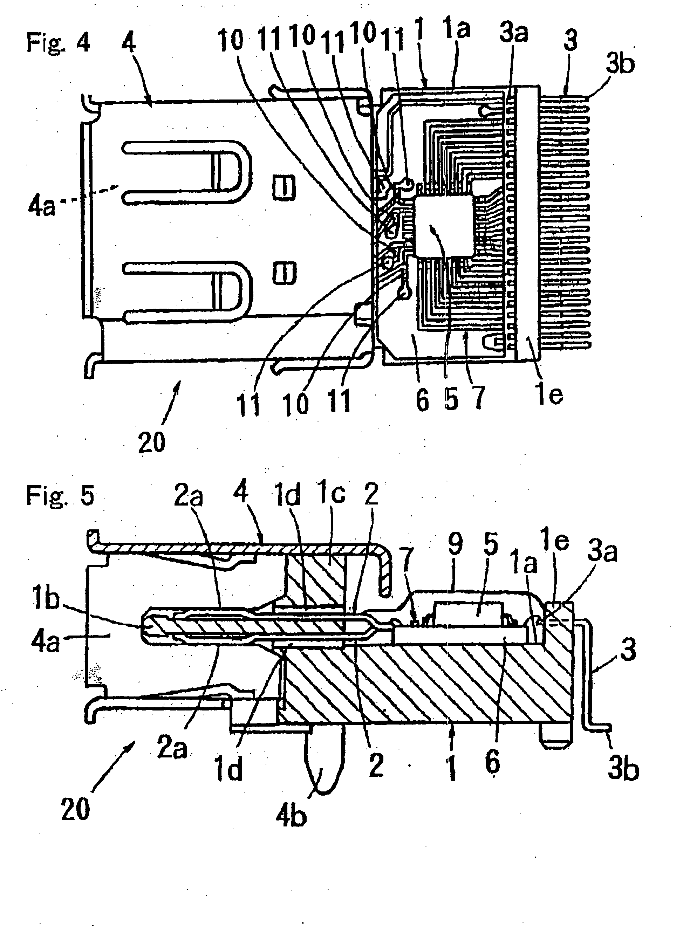

The contact 2 is connected from one end portion to a central portion of a connecting portion (not shown) of the connector plug X mate with the contact supporting portion 1b. As shown in Fig. 5, contact touching portions 2a of the contacts 2 which are directly in contact with the connector plug X are manufactured so as to be rounded.

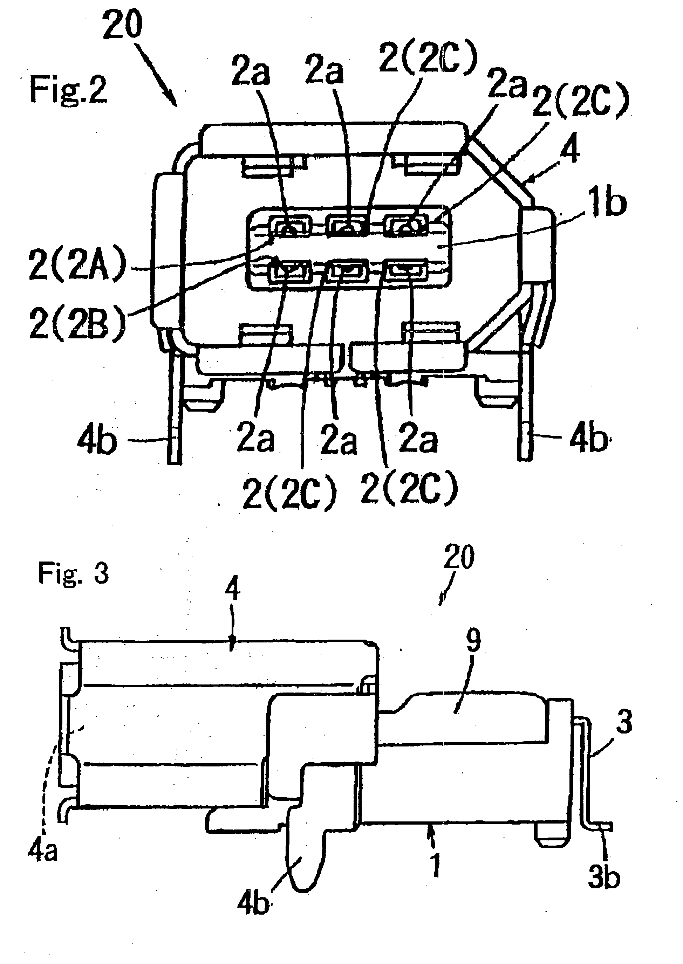

As shown in Fig. 2, the contacts 2 are arranged at upper and lower portions on both sides of the contact supporting portion 1b in its thickness direction and three contacts of each of the upper and lower portions are arranged at intervals of a predetermined distance in its width direction and protrude from the one end of the housing 1 in a state of being pressed and held in contact press-fitting holes 1d provided in the contact holding portion 1c which consists of the one end of the housing 1.

More specifically, as-shown in Fig. 1, six contacts 2 protrude in total, in which one of two long contacts is a contact 2B for a power supply, the other is a contact 2A for ground and the remaining four contacts are contacts 2C for digital signals .

The terminals 3 are pressed and held in a terminal press-fitting hole If provided in a terminal holding portion le consisting of the other end of the housing 1. As shown in Fig. 4, substrate connecting portions 3a comprising one end portion of the terminals 3 protruding to the side of the substrate bonded portion 1a of the housing 1 are electrically connected to patterns 7 provided on the substrate 6 by wire bonding or the like. In addition, as shown in Fig. 3, the other end portion protruding to the other side of the one end portion are SMD terminal portions 3b which are electrically connected to a printed circuit board (not shown) mounting the connector receptacle 20.

The shell (shielding member) 4 is formed of an electro-conductive material and as shown in Fig. 5, it is formed to be almost cylindrical from the contacts 2 so as to be able to surround and shield the region of the contact holding portion 1c of the housing. An opening portion of the almost cylindrical shell 4 is an inserting port 4a into which the connector plug X is to be inserted and mate with. In this shell 4, a shell terminal 4b is provided, which is electrically connected to the printed circuit board (not shown) mounting the connector receptacle 20.

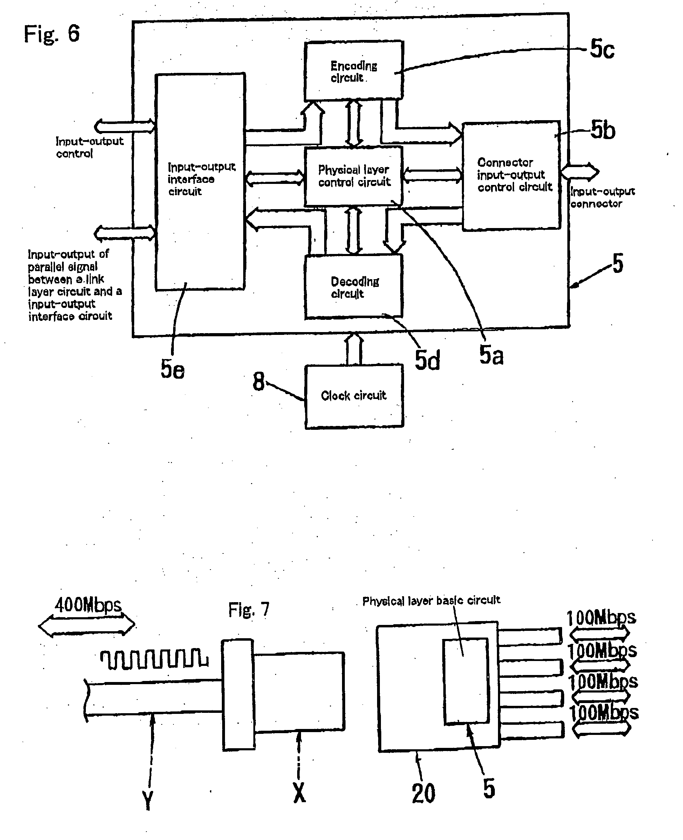

As described above, the substrate 6 is bonded and fixed on the substrate bonded portion 1a of the housing 1 and on an opposite surface of the bonded surface, that is, on an upper surface, the physical layer basic circuit 5 to be described later is mounted. In addition, as shown in Fig. 4, the patterns 7 connected to the physical layer basic circuit 5 are provided on the upper surface of the substrate 6. As described above, the patterns 7 are electrically connected to the contacts 2 and the terminals 3 by wire bonding or the like. Terminating resistances 10 corresponding to characteristic impedance of a cable Y (referring to Fig. 7) provided with the connector plug X to be connected to the connector receptacle 20 are connected to the patterns 7. The lower surface of the substrate 6 is a ground surface and it is connected to the patterns 7 on the upper surface and to the terminals 3 by through holes 11 and via holes (not shown).

As shown in Fig. 5, the physical layer basic circuit 5 is mounted on the substrate 6 in a state of being molded and protected by a molding resin 9. In addition, in Figs. 1 and 4, the molding resin 9 is not shown. The physical layer basic circuit 5 may be mounted onto the substrate 6 in a state of a bare chip.

The physical layer basic circuit 5 performs predetermined operations such as serial-parallel conversion, encoding and decoding operations, and connector input-output control so that a data signal is communicated in series with the connector plug X at each of the plurality of contacts 2, mores specifically, at each of contacts 2c for the digital signals and the data signal is communicated in parallel with the link layer circuit (not shown) which is an upper layer circuit for communication.

As shown in Fig. 6, the physical layer basic circuit 5 comprises a physical layer control circuit 5a, a connector input-output control circuit 5b, an encoding circuit 5c, a decoding circuit 5d and an input-output interface circuit 5e and they are constructed to a large-scale integrated circuit together with a clock circuit 8. In addition, the clock circuit 8 may be designed as such that it is combined in the physical basic circuit 5 itself.

The physical layer control circuit 5a mainly responses a request of arbitration from the link layer circuit which is an upper layer for communication, resets a physical layer circuit consisting of the physical layer basic circuit 5 and the terminating resistance 10 to be described later, arbitrates the communication with an outer physical layer circuit (not shown) which is a lower layer circuit of the link layer circuit for communication and is different from the above-described physical layer circuit, and maintains and controls other circuits among the physical layer circuits.

The connector input-output control circuit 5b is connected to the above-described contacts 2c for the digital signal and mainly outputs and drives a signal transmitted from the encoding circuit 5c, to the connector plug X, selects an arbitration control signal and the data signal out of the signals input from the connector plug X and transmits the signal to the decoding circuit 5d.

The encoding circuit 5c turns the serial data signal input from the above-mentioned link layer circuit through the input-output interface circuit 5e into the data signal and a strobe signal, that is, performs encoding operation. The decoding circuit 5d regenerates the data signal according to the signal from the connector plug X in synchronized with a clock input from the clock circuit 8, that is, performs decoding operation. In addition, the clock may be input from the clock circuit 8 provided outside the connector receptacle 20 through the terminals 3 of the connector receptacle 20.

The input-output interface circuit 5e controls input-output with the above-described link layer circuit and in addition, converts the parallel data signal input from the above-described link layer circuit to the serial data signal, transmits the serial data signal to the encoding circuit 5c, converts the serial data signal from the decoding circuit 5d to the parallel data signal and outputs the parallel data signal to the link layer circuit.

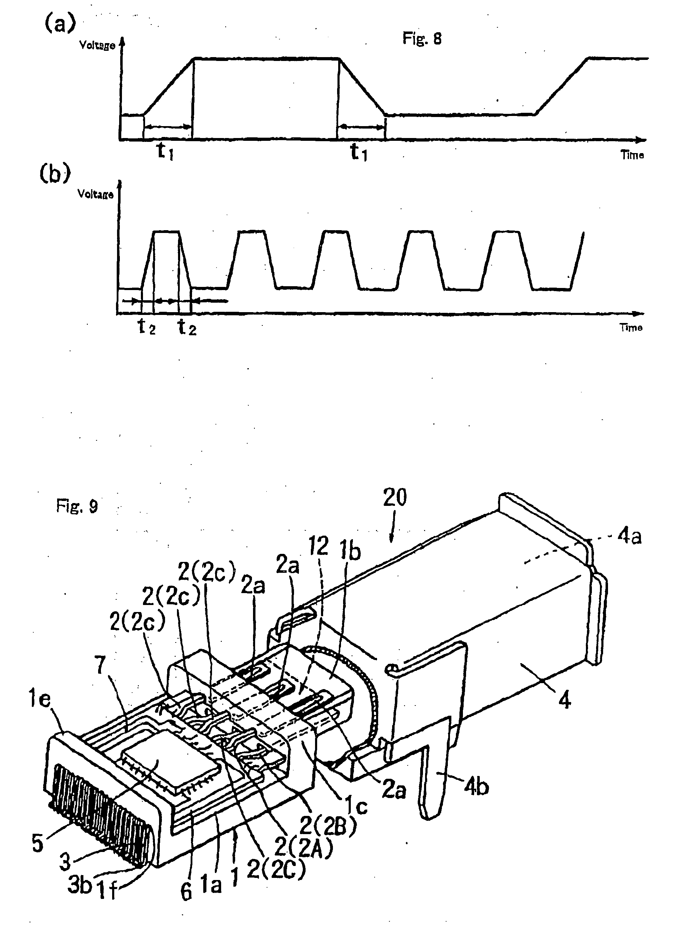

More specifically, as shown in Fig. 7, when for example, the parallel data signal is communicated in parallel at 4 bits of 100Mbps, the serial data signal is communicated at 400Mbps. That is, the parallel data signal is transmitted through transmission lines which are four times as many as that of the serial data signal. As shown in Fig. 8(a) and 8(b), a rise time and fall time t₁ of the parallel data signal is four times as long as a rise time and fall time t₂ of the serial data signal. In addition, the parallel data signal is not limited to be communicated in parallel at 4 bits of 100Mbps.

According to the above connector receptacle 20, since the physical layer basic circuit 5 is provided in the connector receptacle 20 itself, a distance between the contacts 2 and the physical layer basic circuit 5 is reduced as compared with the conventional example in which the physical layer basic circuit 5 is mounted onto the printed circuit board. Consequently, it is not necessary to pay so much attention as in the conventional example in designing a pattern layout so as to prevent influence on the EMI and transmission characteristics, and it is easy to design the layout of the patterns constituting the transmission lines for the data signal.

In addition, when the data signal is communicated in parallel, it is transmitted through the transmission lines which are four times as many as compared with those of the communication in series. As a result, when the data signal is communicated in parallel, the rise time and fall time of the data signal is four times as long as that of the serial communication. Consequently, a high-frequency ingredient is alleviated and the EMI can be reduced.

### [Embodiment 2]

Then, a connector receptacle according to an embodiment 2 of the present invention will be described in reference to Figs. 9 to 13. In addition, in Figs. 9 to 11, a molding resin 9 is not shown. Furthermore, portions substantially having the same functions as in the embodiment 1 are allotted to the same reference numerals and characters and only portions different from those in the embodiment 1 will be described.

The connector receptacle 20 according to this embodiment of the present invention is basically the same as in the embodiment 1 except that a data signal is communicated in series from contacts 2 to a physical layer basic circuit 5 through transmission lines having almost constant characteristic impedance, and the center of the upper and lower contacts 2 is positioned at almost the same plane as an upper surface of a substrate 6.

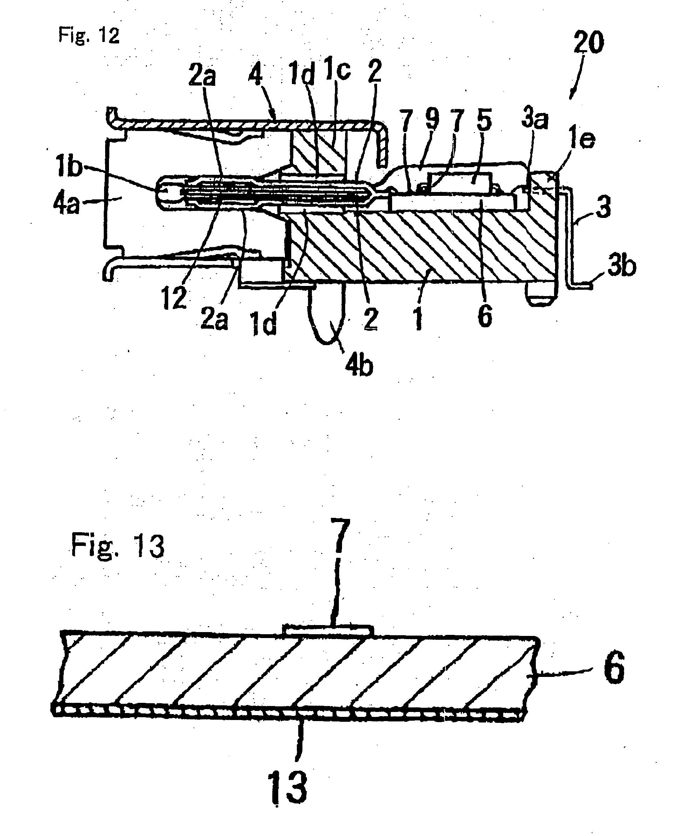

Specifically, as shown in Fig. 12, a contact supporting portion 1b is provided with a ground plane 12 at a central portion in its thickness direction so as to have a microstrip structure, in which the characteristic impedance of the contact 2 is kept almost constant so as to be matched with characteristic impedance of a cable Y provided with a connector plug X to be connected to the connector receptacle 20.

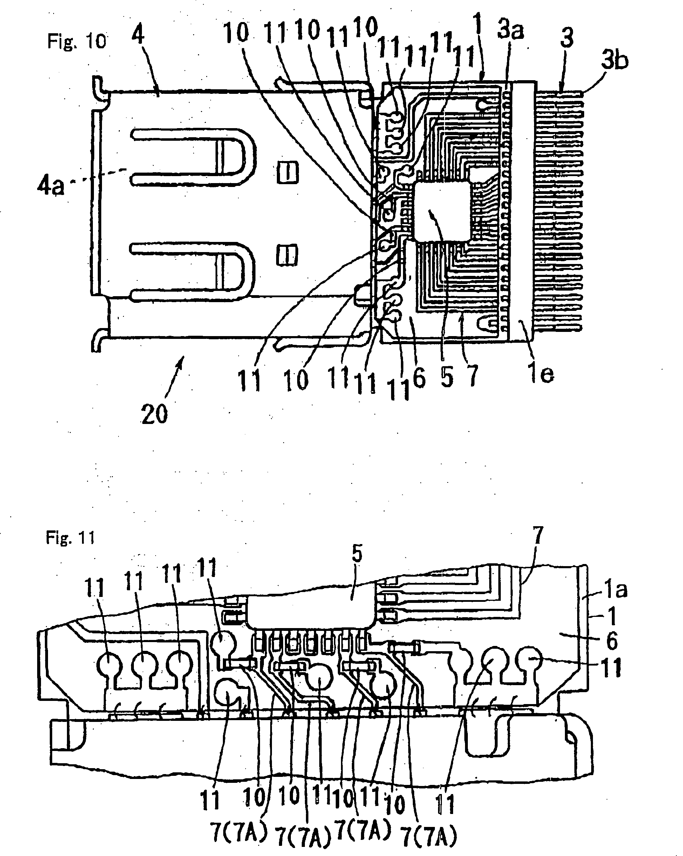

As shown in Fig. 11, the patterns 7A of the patterns 7 provided on the upper surface of the substrate 6, which are disposed between connecting portions with the contacts by wire bonding and the terminating resistances 10, each have a constant width dimension. In addition, it is desirable that the patterns 7 between the terminating resistance 10 and the physical layer basic circuit 5 have the same width. As shown in Fig. 13, the substrate 6 is provided with a ground plane 13 on its lower surface and has the microstrip structure so as to correspond to the characteristic impedance of the contact 2.

Thus, the transmission lines from the contacts 2 to the physical layer basic circuit 5 have almost the constant characteristic impedance. In addition, the ground plane 13 of the substrate 6 is electrically connected to the ground plane 12 of the contacts 2 by wire bonding or the like. Furthermore, as these electrically connecting portions are increased, the EMI characteristic is improved.

According to the connector receptacle 20 of this embodiment, in addition to the effect in the embodiment 1 of the present invention, since the data signal is serially communicated through the patterns 7 serving as the transmission lines having almost the constant characteristic impedance from the contacts 2 to the physical layer basic circuit 5, the reflection of the data signal at the time of the input-output can be reduced.

In addition, since the contact 2 is positioned at almost the same plane as the substrate 6, there is no sharp bending portion which is not good for transmission characteristics and thus, the transmission characteristics can be improved.

### [Embodiment 3]

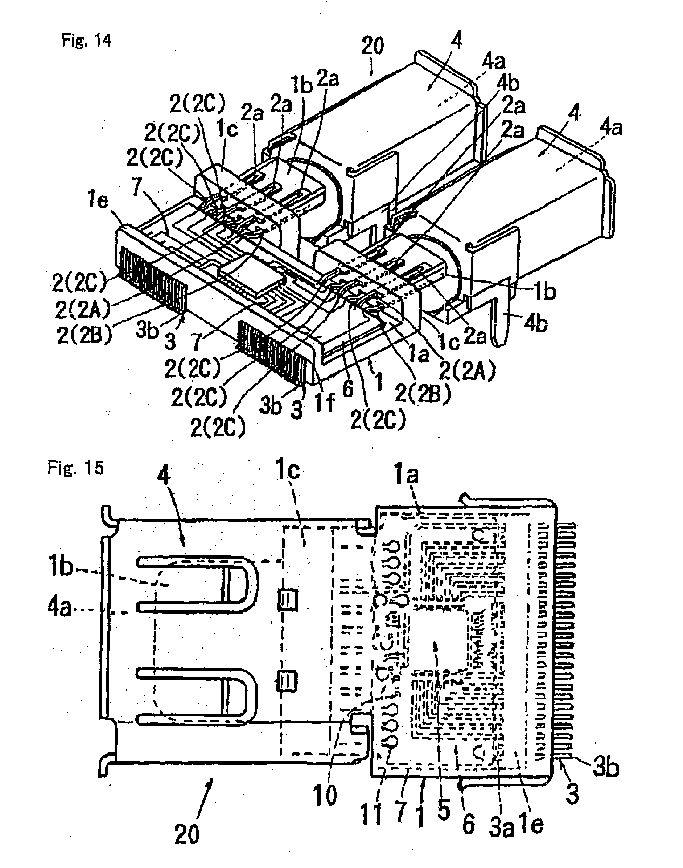

Then, a connector receptacle according to an embodiment 3 of the present invention will be described in reference to Figs. 14 to 17. In addition, in Figs. 14 to 16, a molding resin 9 is not shown. Furthermore, portions substantially having the same functions as in the embodiment 2 are allotted to the same reference numerals and characters and only portions different from those in the embodiment 2 will be described.

The connector receptacle 20 according to this embodiment of the present invention is basically the same as in the embodiment 2 except that a data signal is serially communicated with contacts 2 through patterns 7 serving as transmission lines having almost the same length between the contacts 2 and the physical layer basic circuit 5. In addition, as shown in Fig. 14, there are two contact supporting portions 1b and two shells 4, contacts 2 are provided both upper and lower portions of each of the two contact supporting portions 1b, and the shell 4 extends so as to shield the patterns 7 serving as transmission lines to which the data signal is transmitted from a connector plug X, from the outside.

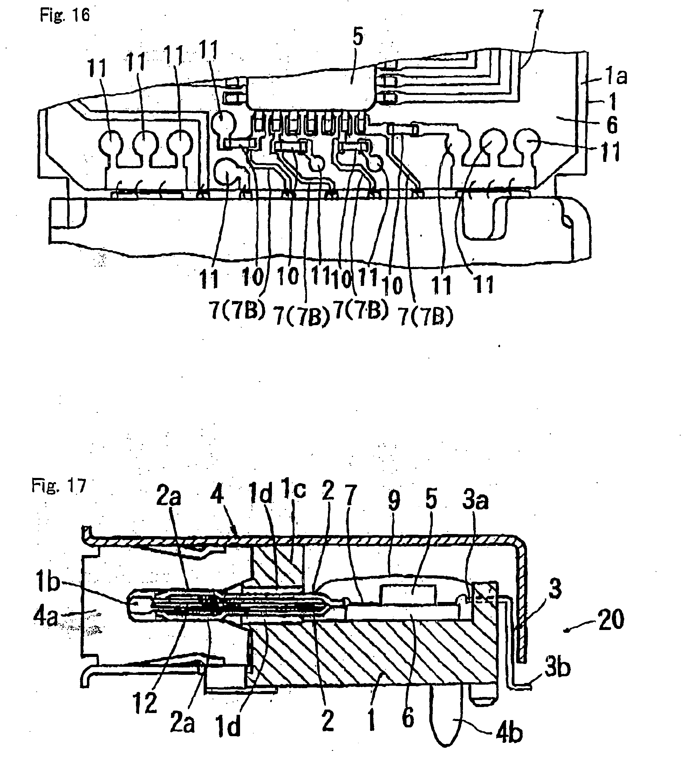

According to the connector receptacle 20, as shown in Fig. 16, the patterns 7 from the contacts 2 to the physical layer basic circuit 5, more specifically, the patterns 7B positioned between a connecting portion with the contacts 2 by wire bonding and terminating resistances 10 each are transmission lines having almost the same length at each of the plurality of contacts 2. In addition, it is desirable that the patterns 7 positioned between the terminating resistances 10 and the physical layer basic circuit 5 are transmission lines each having the same length at each of the contacts 2 when the data signal is communicated in series.

In this case, the physical layer basic circuit 5 performs predetermined operations such as serial-parallel conversion, encoding and decoding operations and connector input-output control so that the data signal is communicated in series with the connector plug X mate with each of the two contact supporting portions 1b and communicated in parallel with a link layer circuit for communication.

According to the connector receptacle 20 of this embodiment of the present invention, in addition to the effect in the embodiment 2, since the date signal is transmitted through transmission lines each having almost the same length between each of the contacts 2 and the physical layer basic circuit 5, a skew between the data signals can be reduced.

In addition, since there are two contact supporting portions 1b, as compared with the case where a plurality of connector receptacles 20 each provided with one contact supporting portion 1b are arranged, the connector receptacle 20 according to this embodiment of the present invention can be easily arranged.

Furthermore, although there are two contact supporting portions 1b, there can be only one physical layer basic circuit 5 which performs predetermined operations such as the serial-parallel conversion, the encoding and decoding operations and the connector input-output control so that the data signal can be communicated in series with the connector plugs X mate with the two contact supporting portions 1b respectively. Consequently, as compared with the case where two physical layer basic circuits 5 are arranged, the whole size can be reduced.

In addition, since the patterns 7 serving as the transmission lines to which the data signal is transmitted from the connector plug X can be shielded from the outside by the shell 4, the EMI can be reduced.

### [Embodiment 4]

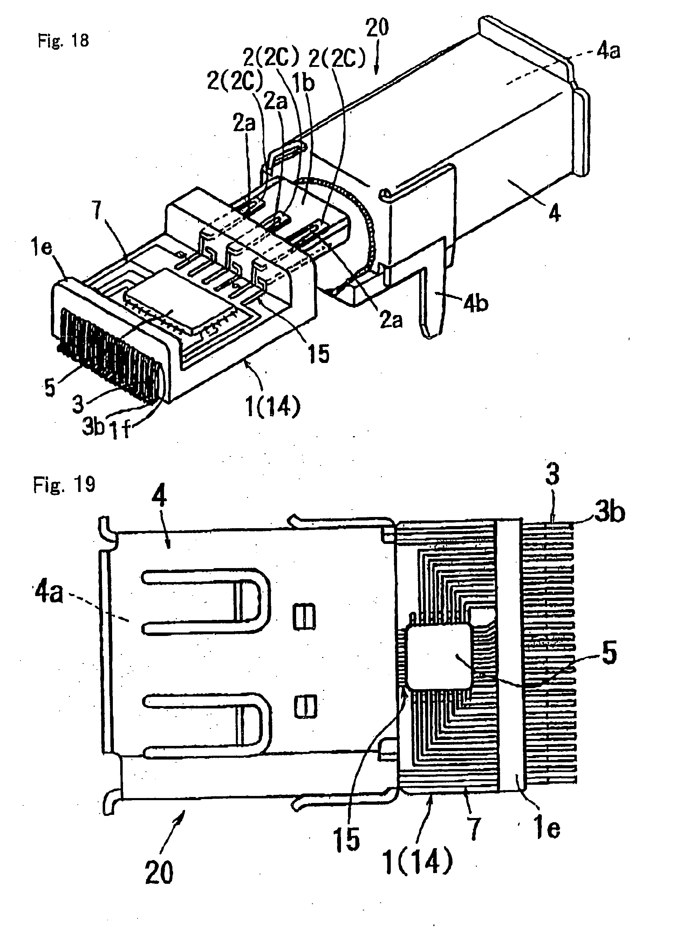

Then, a connector receptacle according to an embodiment 4 of the present invention will be described in reference to Figs. 18 to 20. In addition, portions substantially having the same functions as in the embodiment 1 are allotted to the same reference numerals and characters and only portions different from those of the embodiment 1 will be described.

While the physical layer basic circuit 5 is provided on the substrate 6 bonded to the substrate bonded portion 1a of the housing 1 according to the above embodiment 1 of the present invention, according to this embodiment of the present invention, a physical layer basic circuit 5 is provided on an MID (Molded Interconnection Device) substrate 14 constituting a housing 1.

More specifically, as shown in Fig. 18, conductive plating patterns 15 are provided on the MID substrate 14 and the physical layer basic circuit 5 is mounted onto the conductive plating patterns 15. As shown in Fig. 20, similar to the embodiment 1 of the present invention, the housing 1 comprising the MID substrate 14 is provided with a contact holding portion 1c having contact press-fitting holes 1d which press in and hold the contacts 2.

According to the connector receptacle 20 of this embodiment of the present invention, in addition to the effect in the embodiment 1, since the contacts 2 are held by the MID substrate 14 on which the physical layer basic circuit 5 is mounted, it is not necessary to additionally provide a member for holding the contacts 2 other than the member on which the physical layer basic circuit 5 is mounted, that is, the MID substrate 14, so that the number of parts can be reduced.

Thus, although the preferred embodiments of the present invention were described, the present invention is not limited to theses embodiments and various changes can be made within the scope of the present invention as defined in the claims.

For example, according to the above-described embodiments 1 to 4, although there are six contacts 2 comprising the contact 2B for a power supply and the contact 2A for ground, the same effect can be obtained even when there are four contacts without the contact 2B for power supply and the contact 2A for ground.

### INDUSTRIAL APPLICABILITY

As described above, according to the connector receptacle of the present invention, the physical layer basic circuit performing operations such as serial-parallel conversion in communicating the data signal is provided in the connector receptacle itself. Therefore, the design for a layout of patterns forming the transmission lines for the data signal can be easily made. Thus, it can be optimally used in a connector apparatus or the like which is used particularly for transmitting a digital signal at high speed.

## Claims

1. A connector receptacle (20) comprising a mating portion to mate with a connector plug (X) and a plurality of contacts (2) connectable to the connector plug (X), the connector receptacle (20) further comprising a physical layer basic circuit (5) performing predetermined operations so that a data signal can be communicated in series with the contacts (2) through the connector plug (X) and the data signal can be communicated in parallel with a link layer circuit (D) for communication; wherein said data signal is transmittable in parallel through transmission lines which are N times as many as compared with those for communication in series, **characterised in that** a rise time and fall time when said data signal is communicated in parallel is N times as long as compared with that when it is communicated in series.

2. A connector receptacle according to claim 1, **characterized in that** said data signal can be communicated in series from said contacts (2) to said physical layer basic circuit (5) through transmission lines (7) each having almost constant characteristic impedance.

3. A connector receptacle according to claim 1, **characterized in that** said data signal is transmittable through transmission lines (7) having almost the same length between each of said plurality of contacts (2) and said physical layer basic circuit (5).

4. A connector receptacle according to claim 1, **characterized in that** said physical layer basic circuit (5) is provided on a substrate (6) and said contacts (2) are positioned almost at the same plane as the substrate (6).

5. A connector receptacle according to claim 1, **characterized in that** a plurality of said mating portions are provided.

6. A connector receptacle according to claim 5, **characterized in that** said physical layer basic circuit (5) performs said predetermined operations so that a data signal can be communicated in series with a plurality of said connector plugs (X) which can mate with the plurality of said mating portions and communicated in parallel with said link layer circuit (D).

7. A connector receptacle according to claim 1, **characterized in that** there is provided a shielding member (4) for shielding transmission lines from the outside through which a data signal is transmitted from said connector plug (X).

8. A connector receptacle according to claim 1, **characterized in that** said physical layer basic circuit (5) is provided on an MID substrate (14) and said contacts (2) are held by the MID substrate (14).

## Patentansprüche

1. Verbinderaufnahme (20) aufweisend einen Passbereich für das Zusammenpassen mit einem Verbinderstecker (X) und mehrere Kontakte (2), die mit dem Verbinderstecker (X) verbindbar sind, welche Verbinderaufnahme (20) weiterhin eine Bitübertragungsschicht-Grundschaltung (5) aufweist, die vorbestimmte Operationen durchführt, so dass ein Datensignal in Serie mit den Kontakten (2) über den Verbinderstecker (X) übertragen werden kann und das Datensignal parallel mit einer Sicherungsschichtschaltung (D) für Kommunikation übertragen werden kann; wobei das Datensignal parallel über Übertragungsleitungen übertragbar ist, die N-mal so viele im Vergleich zu denjenigen für die Übertragung in Serie sind, **dadurch gekennzeichnet, dass** eine Anstiegszeit und eine Abfallzeit, wenn das Datensignal parallel übertragen wird, N-mal so lang im Vergleich zu denjenigen, wenn es in Serie übertragen wird, sind.

2. Verbinderaufnahme nach Anspruch 1, **dadurch gekennzeichnet, dass** das Datensignal in Serie von den Kontakten (2) zu der Bitübertragungsschicht-Grundschaltung (5) über Übertragungsleitungen (7) übertragen werden kann, die jeweils einen nahezu konstanten Wellenwiderstand haben.

3. Verbinderaufnahme nach Anspruch 1, **dadurch gekennzeichnet, dass** das Datensignal über Übertragungsleitungen (7) übertragbar ist, die nahezu dieselbe Länge zwischen jedem der mehreren Kontakte (2) und der Bitübertragungsschicht-Grundschaltung (5) haben.

4. Verbinderaufnahme nach Anspruch 1, **dadurch gekennzeichnet, dass** die Bitübertragungsschicht-Grundschaltung (5) auf einem Substrat (6) vorgesehen ist und die Kontakte (2) nahezu in derselben Ebene wie das Substrat (6) positioniert sind.

5. Verbinderaufnahme nach Anspruch 1, **dadurch gekennzeichnet, dass** mehrere der Passbereiche vorgesehen sind.

6. Verbinderaufnahme nach Anspruch 5, **dadurch gekennzeichnet, dass** die Bitübertragungsschicht-Grundschaltung (5) die vorbestimmten Operationen so durchführt, dass ein Datensignal in Serie mit mehreren der Verbinderstecker (X), die mit den mehreren Passbereichen zusammenpassen können, und parallel mit der Sicherungsschichtschaltung (D) übertragen werden kann.

7. Verbinderaufnahme nach Anspruch 1, **dadurch gekennzeichnet, dass** ein Abschirmteil (4) zum Abschirmen von Übertragungsleitungen gegenüber der Außenseite vorgesehen ist, durch die ein Datensignal von dem Verbinderstecker (X) übertragen wird.

8. Verbinderaufnahme nach Anspruch 1, **dadurch gekennzeichnet, dass** die Bitübertragungsschicht-Grundschaltung (5) auf einem MID-Substrat (14) vorgesehen ist und die Kontakte (2) von dem MID-Substrat (14) gehalten werden.

## Revendications

1. Embase de connecteur (20) comprenant une partie d'accouplement destinée à s'accoupler à une fiche de connecteur (X) et une pluralité de contacts (2) qui peuvent être connectés à la fiche de connecteur (X), l'embase de connecteur (20) comprenant en outre un circuit de base de couche physique (5) qui exécute des opérations prédéterminées de telle sorte qu'un signal de données puisse être transmis en série avec les contacts (2) par l'intermédiaire de la fiche de connecteur (X) et que le signal de données puisse être transmis en parallèle avec un circuit de couche de liaison (D) pour une communication ; dans lequel ledit signal de données peut être transmis en parallèle par l'intermédiaire de lignes de transmission dont le nombre est N fois celui pour une communication en série, **caractérisé en ce que** le temps de montée et le temps de descente, lorsque ledit signal de données est transmis en parallèle, durent N fois plus longtemps par rapport au cas où il est transmis en série.

2. Embase de connecteur selon la revendication 1, **caractérisée en ce que** ledit signal de données peut être transmis en série à partir desdits contacts (2) vers ledit circuit de base de couche physique (5) par l'intermédiaire de lignes de transmission (7) qui présentent chacune une impédance caractéristique presque constante.

3. Embase de connecteur selon la revendication 1, **caractérisée en ce que** ledit signal de données peut être transmis par l'intermédiaire de lignes de transmission (7) qui présentent presque la même longueur entre chacun des contacts de ladite pluralité de contacts (2) et ledit circuit de base de couche physique (5).

4. Embase de connecteur selon la revendication 1, **caractérisée en ce que** ledit circuit de base de couche physique (5) est disposé sur un substrat (6) et lesdits contacts (2) sont positionnés presque dans le même plan que le substrat (6).

5. Embase de connecteur selon la revendication 1, **caractérisée en ce qu'**une pluralité desdites parties d'accouplement sont prévues.

6. Embase de connecteur selon la revendication 5, **caractérisée en ce que** ledit circuit de base de couche physique (5) exécute lesdites opérations prédéterminées de telle sorte qu'un signal de données puisse être transmis en série avec une pluralité desdites fiches de connecteur (X) qui peuvent s'accoupler à la pluralité desdites parties d'accouplement, et être transmis en parallèle avec ledit circuit de couche de liaison (D).

7. Embase de connecteur selon la revendication 1, **caractérisée en ce qu'**il est prévu un élément de blindage (4) de manière à blinder les lignes de transmission à partir de l'extérieur et à travers lesquelles un signal de données est transmis à partir de ladite fiche de connecteur (X).

8. Embase de connecteur selon la revendication 1, **caractérisée en ce que** ledit circuit de base de couche physique (5) est disposé sur un substrat MID (acronyme de Molded Interconnection Device, ce qui signifie dispositif d'interconnexion moulé) (14) et lesdits contacts (2) sont maintenus par ledit substrat MID (14).
